(19) Europäisches Patentamt / European Patent Office / Office européen des brevets

(11) **EP 4 673 755 B1**

(12) **EUROPÄISCHE PATENTSCHRIFT**

(45) Veröffentlichungstag und Bekanntmachung des Hinweises auf die Patenterteilung:
**03.06.2026 Patentblatt 2026/23**

(21) Anmeldenummer: **24714418.1**

(22) Anmeldetag: **19.03.2024**

(51) Internationale Patentklassifikation (IPC):
**G01R 27/18** (2006.01)   **G01R 27/20** (2006.01)
**G01R 27/02** (2006.01)

(52) Gemeinsame Patentklassifikation (CPC):
**G01R 27/025; G01R 27/18; G01R 27/2605**

(86) Internationale Anmeldenummer:
**PCT/EP2024/057305**

(87) Internationale Veröffentlichungsnummer:
**WO 2024/200115 (03.10.2024 Gazette 2024/40)**

(54) **VERFAHREN ZUR BESTIMMUNG EINES ISOLATIONSWIDERSTANDS UND EINER ABLEITKAPAZITÄT EINES UNGEERDETEN STROMVERSORGUNGSSYSTEMS**

METHOD FOR DETERMINING AN INSULATION RESISTANCE AND A DISCHARGE CAPACITANCE OF AN UNEARTHED POWER SUPPLY SYSTEM

PROCÉDÉ DE DÉTERMINATION D'UNE RÉSISTANCE D'ISOLATION ET D'UNE CAPACITÉ DE DÉCHARGE D'UN SYSTÈME D'ALIMENTATION ÉLECTRIQUE NON MIS À LA TERRE

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität: **29.03.2023 DE 102023107987**

(43) Veröffentlichungstag der Anmeldung:
**07.01.2026 Patentblatt 2026/02**

(73) Patentinhaber: **Bender GmbH & Co. KG
35305 Grünberg (DE)**

(72) Erfinder: **SYLLA, Michael
36318 Schwalmtal (DE)**

(74) Vertreter: **advotec.
Patent- und Rechtsanwaltspartnerschaft mbB
Georg-Schlosser-Straße 6
35390 Gießen (DE)**

(56) Entgegenhaltungen:
**EP-B1- 2 433 147    CN-A- 113 655 282**

- KEUCHEL U: "EIN NEUES VERFAHREN ZUR PARAMETERSCHATZUNG UND STRUKTURSELEKTION FUR LINEARE MEHRGROSSENREGELSYSTEME", AUTOMATISIERUNGSTECHNIK - AT, OLDENBOURG WISSENSCHAFTSVERLAG, MUNCHEN, DE, vol. 43, no. 10, 1 October 1995 (1995-10-01), pages 458 - 466, XP000534068, ISSN: 0178-2312
- JEPSEN O N ET AL: "REKURSIVE METHODEN KLEINSTER FEHLERQUADRATE UNTER VERWENDUNG ORTHOGONALER TRANSFORMATIONEN. ÖRECURSIVE LEAST SQUARES METHODS BASED ON ORTHOGONAL TRANSFORMATIONS", AUTOMATISIERUNGSTECHNIK - AT, OLDENBOURG WISSENSCHAFTSVERLAG, MUNCHEN, DE, vol. 41, no. 11, 1 November 1993 (1993-11-01), pages 407 - 413, XP000415737, ISSN: 0178-2312

**Beschreibung**

Die Erfindung betrifft ein Verfahren zur Bestimmung eines Isolationswiderstands und einer Ableitkapazität eines ungeerdeten Stromversorgungssystems gemäß dem Oberbegriff des Anspruchs 1.

Bei erhöhten Anforderungen an die Betriebs-, Brand und Berührungssicherheit kommt die Netzform eines ungeerdeten Stromversorgungssystems zum Einsatz, die auch als isoliertes Netz (IT-Netz) oder als IT-Stromversorgungssystem (frz. Isolé Terre - IT) bezeichnet wird. Bei dieser Art des Stromversorgungssystems sind dessen aktive Teile von dem Erdpotenzial - gegenüber "Erde" - getrennt. Der Vorteil dieser Netze liegt darin, dass bei einem Isolationsfehler (erster Fehler), wie beispielsweise einem Erdschluss eines aktiven Leiters des ungeerdeten Stromversorgungssystems, die Funktion der angeschlossenen elektrischen Verbraucher nicht beeinträchtigt wird, da sich wegen des im Idealfall unendlich großen Impedanzwertes zwischen dem aktiven Leiter des Netzes und Erde kein geschlossener Stromkreis ausbilden kann. Ein elektrischer Widerstand gegenüber dem Erdpotenzial (gegen Erde) bildet dabei als reelle Komponente (Realteil) in Parallelschaltung mit einer Ableitkapazität als Imaginärteil die komplexwertige Isolationsimpedanz des ungeerdeten Stromversorgungssystems.

Der als Isolationswiderstand bezeichnete elektrische Widerstand des ungeerdeten Stromversorgungssystems gegen das Erdpotenzial muss daher vorschriftsmäßig mit einem normgerechten Isolationsüberwachungsgerät (Insulation Monitoring Device - IMD) überwacht werden, da durch einen möglichen weiteren Fehler an einem anderen aktiven Leiter (zweiter Fehler) eine Fehlerschleife entstünde und der dabei fließende Fehlerstrom in Verbindung mit einer Überstrom-Schutzeinrichtung eine Abschaltung der Anlage mit Betriebsstillstand zur Folge hätte.

Neben passiven Isolationsüberwachungsgeräten, die eine Netzspannung des ungeerdeten Stromversorgungssystems als treibende Quelle für einen Messstrom nutzen um einen Isolationsfehler zu detektieren, sind aus dem Stand der Technik aktiv arbeitende Isolationsüberwachungsgeräte bekannt. Diese weisen einen zwischen einem oder mehreren aktiven Leiter(n) des ungeerdeten Stromversorgungssystems und dem Erdpotenzial verlaufenden Messpfad auf, der einen internen Messspannungsgenerator umfasst. Eine von dem Messspannungsgenerator erzeugte Messspannung treibt aktiv einen Messstrom, der über den/die aktiven Leiter und über den Isolationswiderstand und die Ableitimpedanz zurück in den Messpfad fließt und dort einen Spannungsabfall an einem in Reihe zu dem Messspannungsgenerator geschalteten Messwiderstand bewirkt. Der über dem Messwiderstand erfasste Spannungsabfall wird zur Bestimmung des Isolationswiderstands und der Ableitimpedanz herangezogen.

Bekannt sind aktive Verfahren, die dem zu überwachenden ungeerdeten Stromversorgungssystem eine rechteckförmige, aus aufeinanderfolgenden Messimpulsen bestehende Messspannung überlagern. Eine zuverlässige Berechnung des Isolationswiderstands ist jedoch nur möglich, wenn die Messspannung eingeschwungen ist, was bei großen Ableitkapazitäten bis zu mehreren Minuten dauern kann.

Darüber hinaus können unerwünschte, aber unvermeidbare Netzspannungsänderungen die Messung stören. Hochfrequente Netzspannungsänderungen (größer als einige Hz) können durch Filter entfernt werden.

Niederfrequente Netzspannungsänderungen von wenigen Hz sind jedoch problematisch, weil diese die Erkennung des Einschwingens behindern und den berechneten Isolationswiderstand verfälschen. Große Spannungsänderungen im niederfrequenten Bereich können daher eine Messung auch unmöglich machen, weil die Messspannung nicht einschwingt.

Aus der Patentschrift EP 2 433 147 B1 ist ein Verfahren bekannt, mit dem der Isolationswiderstand ermittelt wird bevor die gemessene Spannung an einem Messwiderstand einen eingeschwungenen Zustand erreicht. Dabei wird der Einschwingvorgang durch ein mathematisches Modell prognostiziert, dessen Parameter iterativ angepasst werden, bis der theoretische und der gemessene Kurvenverlauf der gemessenen Spannung möglichst gut übereinstimmen. Der Isolationswiderstand kann dann anhand der Modellparameter berechnet werden. Störende Netzspannungsänderungen werden durch Filter und Differenzbildung von zwei aufeinanderfolgenden Messpulsen kompensiert. Allerdings erscheint die Eliminierung von niederfrequenten Netzspannungsänderungen ebenfalls problematisch. Als nachteilig erweist sich weiterhin die rechenaufwendige Matrixinversion zur Bestimmung der Modellparameter.

Der vorliegenden Erfindung liegt somit die Aufgabe zu Grunde, in einem ungeerdeten Stromversorgungssystem eine möglichst schnelle, genaue und robuste Messung des Isolationswiderstands und der Ableitkapazität durchführen zu können, insbesondere soll in DC-Stromversorgungssystemen der störende Einfluss niederfrequenter Netzspannungsänderungen in Verbindung mit einer rechentechnisch effizienten Implementierung vermindert werden.

Diese Aufgabe wird durch ein Verfahren mit den Merkmalen des Anspruchs 1 gelöst.

Auf dem Stand der Technik beruhend wird zunächst eine Messspannung in Reihenschaltung mit einem Messwiderstand einpolig oder zweipolig zwischen jeweils einen der aktiven Leiter angekoppelt und ein - infolge eines von der Messspannung getriebenen Messstroms bewirkter - Spannungsabfall über dem jeweiligen Messwiderstand gemessen.

In DC-Stromversorgungssystemen erweist sich eine zweipolige Ankopplung als zweckmäßig, weil so das Problem niederfrequenter Netzspannungsänderungen besonders wirksam gelöst wird. In AC- und 3AC-Stromversorgungssystemen reicht eine einpolige Ankopplung aus, da die Netzfrequenz durch Filterung entfernt werden kann.

Aus den Spannungsverläufen der Messspannung, der Netzspannung und dem Spannungsabfall an dem jeweiligen Messwiderstand werden zeit- und wertdiskrete Abtastwertfolgen der Messspannung, der Netzspannung und einer gemessenen Spannung erzeugt.

Die kontinuierlichen Signalverläufe der Netzspannung (Nennspannung des ungeerdeten Stromversorgungssystems) und der angelegten, in einem Messsignalgenerator erzeugten, Messspannung sowie der erfassten Spannungsabfälle an den Messwiderständen werden durch Abtasteinrichtungen (Analog-Digital-Umsetzer - ADU) in zeit- und wertdiskrete Signale überführt, um sie als Abtastwertfolgen einer digitalen Signalverarbeitung zugänglich zu machen.

Die so erzeugten Abtastwertfolgen bilden Eingangs- und Ausgangsgrößen eines funktionalen Ersatzschaltbildes des betrachteten ungeerdeten Stromversorgungssystems mit Isolationsüberwachung, wobei dessen mathematische Beschreibung durch physikalische Gesetzmäßigkeiten (ohmsches Gesetz) und die kirchhoffschen Sätze in linearen Netzen (Strom-Spannungs-Beziehungen) gegeben ist.

Auf Grundlage dieser Gesetzmäßigkeiten wird eine lineare Differenzengleichung implementiert, in der sich eine gemessene Spannung - entspricht einem gemessenen Spannungsabfall bei einpoliger Ankopplung oder der Summe der gemessenen Spannungsabfälle bei zweipoliger Ankopplung - als Funktion der Messspannung und der Netzspannung ausdrücken lässt, wobei zu ermittelnde Netzparameter des ungeerdeten Stromversorgungssystems Koeffizienten der linearen Differenzengleichung darstellen. Die Netzparameter werden dabei aus den Messwiderständen, aus den zu bestimmenden Isolationswiderständen und aus den zu bestimmenden Ableitkapazitäten gebildet. Zur rechentechnischen Vereinfachung sind die Widerstandswerte durch Leitwerte ausgedrückt.

Durch das Einbeziehen der Netzspannung in die Strom-Spannungs-Beziehungen der linearen Differenzengleichung ist es nicht notwendig, die Netzspannung aus der Messspannung, beispielsweise durch Filterung oder weitere signalverarbeitenden Maßnahmen, zu entfernen. Der Schaltungsaufwand wird in vorteilhafter Weise reduziert und das erfindungsgemäße Messverfahren wird störsicherer.

Zudem ist eine schnellere und durchgehende Messung bei langsamen, niederfrequenten Änderungen der Netzspannung möglich. Dies ist insbesondere bei PV-Anlagen von Vorteil, da deren DC-Netzspannung in Abhängigkeit der Intensität der Sonneneinstrahlung schwankt.

Im Vergleich zu aus dem Stand der Technik vorherrschenden Verfahren, bei denen eine stabile Netzspannung sowie eine eingeschwungene Messspannung zur Ermittlung des Isolationswiderstands vorausgesetzt wird, kann mit dem erfindungsgemäßen Verfahren kontinuierlich weiter gemessen werden.

In einem nächsten Schritt wird für k=1, 2 bis N Messzeitpunkte mit der Abtastperiode Taus den Abtastwertfolgen der Messspannung, der Netzspannung, der gemessenen Spannung und den Netzparametern ein Messwert-Gleichungssystem aus N linearen Differenzengleichungen implementiert.

Für N > 4 Messzeitpunkte ergibt sich ein überbestimmtes Messwert-Gleichungssystem. Für dieses überbestimmte Messwert-Gleichungssystem existiert im Regelfall kein Lösungsvektor, vorliegend somit kein Satz von Netzparametern (Koeffizientenvektor), der alle N linearen Differenzengleichungen exakt löst.

Daher erfolgt ein Berechnen von geschätzten Netzparametern als Näherungslösung des Messwert-Gleichungssystems, wobei eine Summe der Fehlerquadrate zwischen den (tatsächlichen) Netzparametern und den geschätzten Netzparametern minimiert wird.

Die geschätzten Netzparameter werden im Sinne der Näherungslösung dann als optimal betrachtet, wenn die sich aus dem verbleibenden (Rest-)Fehler zwischen den tatsächlichen Netzparametern und den geschätzten Netzparametern ergebende Summe der Fehlerquadrate minimal wird.

Die Lösung dieses Minimierungsproblems oder Ausgleichsproblems erfolgt durch Minimieren der Summe der Fehlerquadrate mittels QR-Zerlegung einer - das Messwert-Gleichungssystem charakterisierenden - Messwertmatrix, wobei das Berechnen der QR-Zerlegung rekursiv erfolgt.

Das N lineare Differenzengleichungen umfassende Messwert-Gleichungssystem kann als Messwert-Matrixgleichung geschrieben werden, in der sich die Abtastwertfolge der gemessenen Spannung (Messwertvektor) als Ergebnis aus der Multiplikation der Messwertmatrix mit dem Koeffizientenvektor (Netzparametervektor) ergibt. Die Elemente der Messwertmatrix entsprechen den Abtastwerten der Messspannung, der Netzspannung und - wegen der iterativen Natur von Differenzengleichungen - vorangegangenen Abtastwerten der gemessenen Spannung.

Eine zur Lösung des Minimierungssproblems mittels eines Gradientenverfahrens benötigte rechenintensive Matrixinvertierung wird durch eine QR-Zerlegung der Messwertmatrix umgangen. Unter ungünstigen Bedingungen - wenn beispielsweise die Messspannung oder die Netzspannung gleich Null sein sollten, würde dies zu Nullspalten und damit zu einer nicht-invertierbaren Matrix führen. In diesem Fall wäre also eine Matrixinvertierung im Gegensatz zu einer QR-Zerlegung nicht möglich.

Die QR-Zerlegung ist demgegenüber numerisch wesentlich stabiler und ermöglicht eine Berechnung der geschätzten Netzparameter auch bei einer schlecht konditionierten Messwertmatrix. Die erfindungsgemäße Berechnung der geschätzten Netzparameter reagiert unempfindlicher gegenüber fehlerhaften Messdaten und auf Rundungsfehler und wird damit genauer.

Ausgehend von einer geometrischen Interpretation des Minimierungsproblems werden die Fehlerquadrate als Quadrat der euklidischen Norm betrachtet. Damit lässt sich unter Anwendung einer QR-Zerlegung der Messwertmatrix das Minimierungsproblem auf eine QR-Matrixgleichung zurückführen. Im Unterschied zu der Messwert-Matrixgleichung, die das aus den Differenzengleichungen bestehende Messwert-Gleichungssystem repräsentiert, wird vorliegend die das Minimierungsproblem lösende (Matrix-)Gleichung, die einen Ergebnisvektor als Matrixprodukt aus einer oberen Dreiecksmatrix und einem geschätzten Netzparametervektor darstellt, als QR-Matrixgleichung bezeichnet.

Eine Lösung für den geschätzten Netzparametervektor wird dann mit zuvor (rekursiv) berechneter oberer Dreiecksmatrix R der QR-Zerlegung und (rekursiv) bestimmtem Ergebnisvektor der QR-Matrixgleichung durch Rückwärtseinsetzen ermittelt.

Erfindungsgemäß erfolgt das Berechnen der QR-Zerlegung rekursiv. Dabei werden die jeweils in einem Verfahrensdurchlauf berechneten Ergebnisse der QR-Zerlegung - die obere Dreiecksmatrix R und der Ergebnisvektor der QR-Matrixgleichung - in dem darauffolgenden Durchlauf durch Einbeziehen aktuell vorliegender Messwerte aktualisiert, sodass eine schrittweise Näherung an die tatsächlichen Netzparameter erfolgt.

Durch die rekursive Berechnung werden der Speicherbedarf und der Rechenaufwand deutlich reduziert, da nur ein aktuell vorliegender Messwertsatz verarbeitet wird. Damit ist eine effiziente Implementierung auf einem Mikrocontroller möglich.

Neben dem Vorteil, dass die rekursive QR-Zerlegung wenig Speicherplatz und Rechenzeit benötigt, erfolgt eine schnelle Anpassung an sich ändernde (tatsächliche) Netzparameter. Ändert sich der augenblicklich wirksame Isolationswiderstand oder die Ableitkapazität, können die Messungen und die Berechnungen aufgrund der kontinuierlichen Adaptierung einfach weitergeführt werden.

Der jeweilige, leiterbezogene Isolationswiderstand und die jeweilige Ableitkapazität werden aus den geschätzten Netzparametern berechnet.

Die Isolationswiderstände und die Ableitkapazitäten werden nicht, wie in dem Stand der Technik üblich, direkt aus den über den Messwiderständen gemessenen Spannungsabfällen, sondern aus den geschätzten Netzparametern berechnet. Es ist deshalb keine zwingende Voraussetzung, dass die gemessene Spannung einen eingeschwungenen Zustand erreicht haben muss, um zuverlässige Berechnungen durchführen zu können.

Zum einen ermöglicht das erfindungsgemäße Verfahren ein schnelles Ermitteln des Isolationswiderstands und der Ableitkapazität und zum anderen erhält man mehr Freiheit bei der Wahl der Signalform der Messspannung. So ist es beispielsweise möglich, auch eine sinusförmige Messspannung oder ein Gemisch aus sinusförmigen Spannungsverläufen unterschiedlicher Frequenz als Messsignal zu wählen.

Die Verfahrensschritte werden mit den jeweils berechneten, geschätzten Netzparametern unter Einbeziehen der für den aktuellen Messzeitpunkt vorliegenden Abtastwerte kontinuierlich wiederholt.

Es findet somit eine laufende Anpassung an den aktuell vorliegenden Isolationszustand des ungeerdeten Stromversorgungssystems statt, wobei durch die rekursive Berechnung eine Ressourcen schonende und schnelle Ermittlung des Isolationswiderstands und der Ableitkapazität gewährleistet ist.

In weiterer Ausgestaltung wird die lineare Differenzengleichung durch Transformieren einer die Strom-Spannungs-Beziehungen beschreibenden linearen algebraischen Gleichung im Frequenzbereich in eine zeitkontinuierliche Differentialgleichung und deren zeitdiskrete Implementierung abgeleitet.

Ausgangspunkt der Implementierung der linearen Differenzengleichung ist eine Beschreibung der aus dem Ersatzschaltbild des betrachteten ungeerdeten Stromversorgungssystems mit Isolationsüberwachung gewonnenen Strom-Spannungs-Beziehungen im Frequenzbereich (Bildbereich) durch eine lineare algebraische Gleichung. Vorzugsweise findet zur Beschreibung der Beziehungen im Frequenzbereich die Laplace-Transformierte Verwendung. In den Zeitbereich überführt ergibt sich daraus eine zeitkontinuierliche Differentialgleichung und aus der anschließenden Zeitdiskretisierung folgt die lineare Differenzengleichung. Deren Anwendung für aufeinanderfolgende Messzeitpunkte (Abtastwerte) ergibt das als Messwert-Matrixgleichung darstellbare Messwert-Gleichungssystem mit der Messwertmatrix zur Bestimmung der Netzparameter.

Bevorzugt erfolgt die rekursive QR-Zerlegung auf Basis einer Rekursionsmatrix.

Eine Startmatrix mit geeigneten initialen Parametern für die obere Dreiecksmatrix der QR-Zerlegung und für den Ergebnisvektor der QR-Matrixgleichung wird in einer Initialisierungsphase des Verfahrens mit dem aktuellen Messwertsatz zu einer Rekursionsmatrix erweitert. In jedem folgenden Verfahrensdurchlauf wird dieser Messwertsatz durch den jeweiligen dann aktuellen Messwertsatz ersetzt. Somit wird bei jedem Verfahrensdurchlauf iterativ die obere Dreiecksmatrix R und der Ergebnisvektor unter Berücksichtigung der jeweils aktuellen Messwerte neu berechnet.

Weiter erfolgt die QR-Zerlegung mittels Givens-Rotation.

Mit dem Verfahren der Givens-Rotation zur Berechnung der oberen Dreiecksmatrix werden in jedem Verfahrensdurchlauf Rotationsmatrizen berechnet, um gezielt Nulleinträge in der Rekursionsmatrix zu erzeugen. Damit stehen am Ende eines jeden Verfahrensdurchlaufs eine aktualisierte obere Dreiecksmatrix R und ein aktualisierter Ergebnisvektor zur Verfügung, mit denen durch Rückwärtseinsetzen die QR-Matrixgleichung gelöst und damit der geschätzte Netzparametervektor bestimmt werden kann.

Mit Vorteil werden bei der rekursiven QR-Zerlegung eine obere Dreiecksmatrix und ein Ergebnisvektor mit einem Forgetting Factor gewichtet.

Die obere Dreiecksmatrix R sowie der Ergebnisvektor der QR-Matrixgleichung werden mit einem Faktor - dem Forgetting Factor - multipliziert, um eine Gewichtung der Messwerte einzuführen.

Der Forgetting Factor führt dazu, dass aktuelle Messwerte stärker gewichtet werden als solche, die in der Vergangenheit liegen. Er besitzt einen typischen Wert in einem Bereich zwischen 0.95 und 1. Je größer dieser Faktor ist, desto stärker werden ältere Messwerte in der Berechnung berücksichtigt. Damit werden Parameteränderungen langsamer erkannt, jedoch werden kurzzeitige Störungen besser gefiltert. Umgekehrt ermöglicht ein kleinerer Faktor eine schnellere Erkennung einer Parameteränderung mit dem Nachteil, dass die Messung störanfälliger wird. Durch die rekursive Berechnung mit Forgetting Factor können solche Änderungen mitverfolgt werden.

Weitere vorteilhafte Ausgestaltungsmerkmale ergeben sich aus der nachfolgenden Beschreibung und den Zeichnungen, die eine bevorzugte Ausführungsform der Erfindung an Hand von Beispielen erläutern. Es zeigen

**Fig. 1:** ein funktionales Ersatzschaltbild eines ungeerdeten DC-Stromversorgungssystems mit Isolationsüberwachung,

**Fig. 2:** ein Ablaufdiagramm des erfindungsgemäßen Verfahrens,

**Fig. 3:** eine Rechteckimpuls-förmige Messspannung,

**Fig. 4:** ein über einem Messwiderstand gemessener Spannungsabfall bei einer Netzspannungsänderung,

**Fig. 5:** einen Zeitverlauf eines berechneten Isolationswiderstands und

**Fig. 6:** einen Zeitverlauf einer berechneten Ableitkapazität.

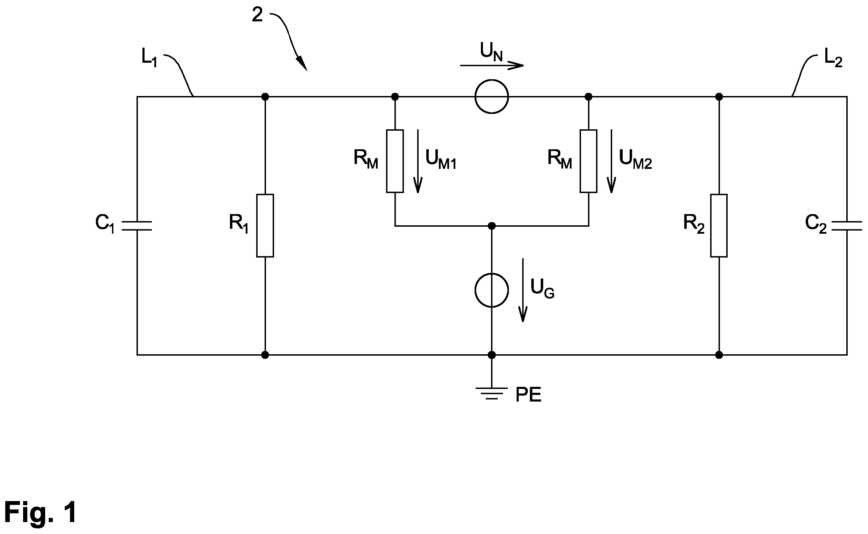

**Fig. 1** zeigt ein funktionales Ersatzschaltbild eines zu überwachenden ungeerdeten Stromversorgungssystems 2 mit der Netzspannung $U_N$.

Das erfindungsgemäße Verfahren ist sowohl in einem DC-Stromversorgungssystem als auch in einem ein- oder mehrphasigen AC-Stromversorgungssystem anwendbar, wobei die Ankopplung der Messspannung $U_G$ hier beispielhaft in einem DC-Stromversorgungssystem zweipolig an zwei aktive Leiter L1, L2 erfolgt.

Eine zwischen aktiven Leitern L1, L2 und Erde PE jeweils wirksame Isolationsimpedanz ist durch einen Isolationswiderstand $R_1$, $R_2$ (Realteil der Isolationsimpedanz) in Parallelschaltung mit einer Ableitkapazität $C_1$, $C_2$ (Imaginärteil der Isolationsimpedanz) dargestellt.

Zur Isolationsüberwachung erzeugt ein Messspannungsgenerator eine Messspannung $U_G$, die einen Messstrom treibt, der über die aktiven Leiter $L_1$, $L_2$, über die Isolationswiderstände $R_1$, $R_2$ sowie über die Ableitkapazitäten $C_1$, $C_2$ fließt und an Messwiderständen $R_M$ jeweils einen Spannungsabfall $U_{M1}$, $U_{M2}$ bewirkt, der gemessen wird und zur Bestimmung des Isolationswiderstands $R_1$, $R_2$ und der Ableitkapazität $C_1$, $C_2$ ausgewertet wird.

In der Praxis erfolgt die Ankopplung der Messspannung $U_G$ über eine Reihenschaltung mit einem hochohmigen Ankoppelwiderstand und einem niederohmigen Messwiderstand. Zur rechentechnischen Vereinfachung sind beide Widerstände zu dem jeweiligen Messwiderstand $R_M$ zusammengefasst worden.

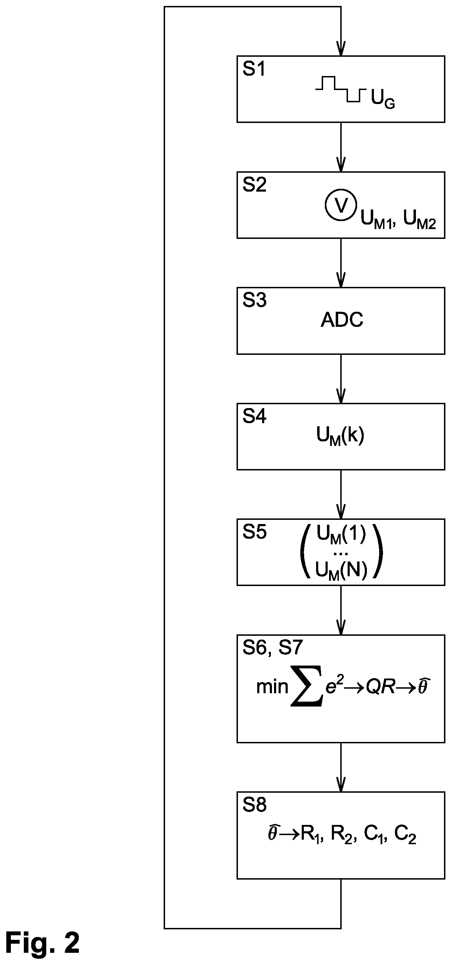

**Fig. 2** beschreibt ein Ablaufdiagramm des erfindungsgemäßen Verfahrens.

Nach einer Initialisierungsphase des Verfahrens, in der Startwerte der Parameter für die obere Dreiecksmatrix der QR-Zerlegung und für den Ergebnisvektor der QR-Matrixgleichung gesetzt werden, erfolgt in den Schritten S1 und S2 ein Schalten der Messspannung $U_G$ mit Messen des jeweiligen über den Messwiderständen $R_M$ aufgrund des Messstroms sich einstellenden Spannungsabfalls $U_{M1}$, $U_{M2}$.

Durch Abtasten und Quantisieren werden in Schritt S3 zeit- und wertdiskrete Abtastwertfolgen $U_G(k)$, $U_N(k)$, $U_M(k)$ der Messspannung $U_G$, der Netzspannung $U_N$ und der Spannungsabfälle $U_{M1}$, $U_{M2}$ erzeugt.

Mit den sich auf Basis des funktionalen Ersatzschaltbildes ergebenden Strom-Spannungs-Beziehungen wird in Schritt S4 eine lineare Differenzengleichung implementiert.

Ausgehend von einer Beschreibung im Frequenzbereich durch die algebraische Gleichung für die gemessene Spannung $U_M$ (diese setzt sich wegen der hier beispielhaft betrachteten zweipoligen Ankopplung aus der Summe der Spannungsabfälle $U_{M1}$, $U_{M2}$ zusammen und würde bei einer nur einpoligen Ankopplung nur dem Spannungsabfall $U_{M1}$ oder $U_{M2}$ entsprechen)

$$U_{M1}(s) + U_{M2}(s) = U_M(s)$$

$$= -2\,\frac{s + \dfrac{G_1 + G_2}{C_1 + C_2}}{s + \dfrac{G_1 + G_2 + 2G_M}{C_1 + C_2}}\,U_G(s) + \frac{C_2 - C_1}{C_1 + C_2} \cdot \frac{s + \dfrac{G_2 - G_1}{C_2 - C_1}}{s + \dfrac{G_1 + G_2 + 2G_M}{C_1 + C_2}}\,U_N(s)$$

$$(\text{Gl. } 1)$$

folgt aus deren Überführung in den Zeitbereich die zeitkontinuierliche Differentialgleichung und aus der anschließenden Zeitdiskretisierung mit dem Index k der Abtastwertfolgen und der Abtastperiode T ergibt sich die lineare Differenzengleichung, in welcher sich die gemessene Spannung $U_M(k)$ als Funktion der Messspannung $U_G(k)$ und der Netzspannung $U_N(k)$ ausdrücken lässt als

$$U_M(k) = -2\,\frac{G_1 + G_2 + \dfrac{1}{T}(C_1 + C_2)}{G_1 + G_2 + 2G_M + \dfrac{1}{T}(C_1 + C_2)}\,U_G(k) - \frac{G_1 - G_2 + \dfrac{1}{T}(C_1 - C_2)}{G_1 + G_2 + 2G_M + \dfrac{1}{T}(C_1 + C_2)}\,U_N(k)$$

$$+ \frac{\dfrac{1}{T}(C_1 - C_2)}{G_1 + G_2 + 2G_M + \dfrac{1}{T}(C_1 + C_2)}\,U_N(k - 1)$$

$$+ \frac{\dfrac{1}{T}(C_1 + C_2)}{G_1 + G_2 + 2G_M + \dfrac{1}{T}(C_1 + C_2)}\,\big(U_M(k - 1) + 2U_G(k - 1)\big)$$

$$(\text{Gl. } 2)$$

In Matrixschreibweise ergibt sich damit:

$$U_M(k) = \big(U_G(k) \quad U_N(k) \quad U_N(k - 1) \quad U_M(k - 1) + 2U_G(k - 1)\big)$$

$$\cdot \begin{pmatrix} -2\,\dfrac{G_1 + G_2 + \dfrac{1}{T}(C_1 + C_2)}{G_1 + G_2 + 2G_M + \dfrac{1}{T}(C_1 + C_2)} \\[4ex] -\dfrac{G_1 - G_2 + \dfrac{1}{T}(C_1 - C_2)}{G_1 + G_2 + 2G_M + \dfrac{1}{T}(C_1 + C_2)} \\[4ex] \dfrac{\dfrac{1}{T}(C_1 - C_2)}{G_1 + G_2 + 2G_M + \dfrac{1}{T}(C_1 + C_2)} \\[4ex] \dfrac{\dfrac{1}{T}(C_1 + C_2)}{G_1 + G_2 + 2G_M + \dfrac{1}{T}(C_1 + C_2)} \end{pmatrix}$$

$$(\text{Gl. } 3)$$

Für k=1, 2 bis N Messzeitpunkte erfolgt daraus in Schritt S5 die Implementierung eines überbestimmten Messwert-Gleichungssystems:

$$\begin{pmatrix} U_M(1) \\ \vdots \\ U_M(N) \end{pmatrix} = \begin{pmatrix} U_G(1) & U_N(1) & U_N(0) & U_M(0) + 2U_G(0) \\ \vdots & \vdots & \vdots & \vdots \\ U_G(N) & U_N(N) & U_N(N-1) & U_M(N-1) + 2U_G(N-1) \end{pmatrix}$$

$$\cdot \begin{pmatrix} -2\dfrac{G_1 + G_2 + \frac{1}{T}(C_1 + C_2)}{G_1 + G_2 + 2G_M + \frac{1}{T}(C_1 + C_2)} \\ -\dfrac{G_1 - G_2 + \frac{1}{T}(C_1 - C_2)}{G_1 + G_2 + 2G_M + \frac{1}{T}(C_1 + C_2)} \\ \dfrac{\frac{1}{T}(C_1 - C_2)}{G_1 + G_2 + 2G_M + \frac{1}{T}(C_1 + C_2)} \\ \dfrac{\frac{1}{T}(C_1 + C_2)}{G_1 + G_2 + 2G_M + \frac{1}{T}(C_1 + C_2)} \end{pmatrix}$$

$$(\mathrm{Gl.}\ 4)$$

welches als Messwert-Matrixgleichung mit dem Messwertvektor y, der Messwertmatrix $\Psi$ und dem Netzparametervektor (Koeffizientenvektor) $\theta$ geschrieben werden kann:

$$\boldsymbol{y} = \boldsymbol{\Psi} \cdot \boldsymbol{\theta}$$

$$(\mathrm{Gl.}\ 5)$$

Der Netzparametervektor $\theta$ besteht aus den Elementen $\theta_i$ (Netzparameter), die aus den zu bestimmenden Netzwerkgrößen $G_1 = 1/R_1$, $G_2 = 1/R_2$, $C_1$ und $C_2$ sowie aus den Messwiderständen $R_M$ gebildet werden.

Da überbestimmte Gleichungssysteme im Allgemeinen keine Lösung besitzen, wird in Schritt S6 eine Näherungslösung berechnet, bei der ein (Rest-)Fehler e verbleibt, der idealerweise nur noch das Messrauschen abbildet. Aus dem Netzparametervektor $\theta$ in den Gleichungen (4) und (5) wird damit ein geschätzter Netzparametervektor $\hat{\theta}$ mit geschätzten Netzparametern $\hat{\theta}_i$:

$$\boldsymbol{y} = \boldsymbol{\Psi} \cdot \widehat{\boldsymbol{\theta}} + \boldsymbol{e}$$

$$(\mathrm{Gl.}\ 6)$$

Die geschätzten Netzparameter $\hat{\theta}_i$ (Elemente des Netzparametervektors $\hat{\theta}$) werden als optimal betrachtet, wenn die Quadratsumme des Fehlers **e** minimal ist:

$$\min_{\widehat{\boldsymbol{\theta}}} \sum_{k=1}^{N} e_k^2 = \min_{\widehat{\boldsymbol{\theta}}} \boldsymbol{e}^T \boldsymbol{e}$$

$$(\mathrm{Gl.}\ 7)$$

Die Lösung dieses Minimierungsproblems mittels eines Gradientenverfahrens verlangt eine Matrixinversion, deren Berechnung numerisch instabil werden kann. Um die Matrixinversion zu umgehen, wird die Gleichung (7) geometrisch interpretiert und als Quadrat der euklidischen Norm betrachtet:

$$\min_{\widehat{\theta}} e^T e = \min_{\widehat{\theta}} \left\| \Psi\widehat{\theta} - y \right\|_2^2$$

$$(\text{Gl. 8})$$

Auf die Messwertmatrix $\Psi$ wird in Schritt S7 die (volle) QR-Zerlegung angewendet mit der orthonormalen Matrix $\mathbf{Q}$ und einer oberen Dreiecksmatrix $\mathbf{R}$, wobei $\mathbf{0}$ die Nullmatrix ist:

$$\Psi = \mathbf{Q}\begin{pmatrix} \mathbf{R} \\ \mathbf{0} \end{pmatrix}$$

$$(\text{Gl. 9})$$

Linksseitige Multiplikation mit $\mathbf{Q^T}$ ergibt wegen der Orthonormalität $\mathbf{Q^T Q = 1}$:

$$\mathbf{Q^T}\Psi = \begin{pmatrix} \mathbf{R} \\ \mathbf{0} \end{pmatrix}$$

$$(\text{Gl. 10})$$

Die Multiplikation des Messwertvektors y kann gleichermaßen aufgeteilt werden in:

$$\mathbf{Q^T} y = \begin{pmatrix} \boldsymbol{c} \\ \tilde{\boldsymbol{c}} \end{pmatrix}$$

$$(\text{Gl. 11})$$

wobei hier $\boldsymbol{c}$ als Ergebnisvektor bezeichnet wird und der Vektor $\tilde{\boldsymbol{c}}$ den verbleibenden Fehler abbildet.

Weil $\boldsymbol{Q}$ orthonormal ist, ändert sich durch die linksseitige Multiplikation mit $\mathbf{Q^T}$ die euklidische Norm nicht - die Multiplikation ist längenerhaltend - und der zu minimierende Ausdruck in Gleichung (8) geht über in

$$\left\| \Psi\widehat{\theta} - y \right\|_2^2 = \left\| \mathbf{Q^T}\left(\Psi\widehat{\theta} - y\right) \right\|_2^2 = \left\| \mathbf{Q^T}\Psi\widehat{\theta} - \mathbf{Q^T}y \right\|_2^2 = \left\| \begin{pmatrix} \mathbf{R} \\ \mathbf{0} \end{pmatrix}\widehat{\theta} - \begin{pmatrix} \boldsymbol{c} \\ \tilde{\boldsymbol{c}} \end{pmatrix} \right\|_2^2$$

$$= \left\| \begin{pmatrix} \mathbf{R}\widehat{\theta} - \boldsymbol{c} \\ \mathbf{0} - \tilde{\boldsymbol{c}} \end{pmatrix} \right\|_2^2 = \underbrace{\left\| \mathbf{R}\widehat{\theta} - \boldsymbol{c} \right\|_2^2}_{=0} + \left\| \tilde{\boldsymbol{c}} \right\|_2^2$$

$$(\text{Gl. 12})$$

Der Ausdruck $\underbrace{\left\| \mathbf{R}\widehat{\theta} - \boldsymbol{c} \right\|_2^2}_{=0} + \left\| \tilde{\boldsymbol{c}} \right\|_2^2$ in Gleichung (12) besitzt ein Minimum, wenn die QR-Matrixgleichung

$$\mathbf{R}\widehat{\theta} = \boldsymbol{c}$$

$$(\text{Gl. 13})$$

erfüllt ist. Der geschätzte Netzparametervektor $\widehat{\theta}$ kann dann in Kenntnis der oberen Dreiecksmatrix $\boldsymbol{R}$ und des Ergebnisvektors $\boldsymbol{c}$ einfach durch Rückwärtseinsetzen ermittelt werden.

Zur Berechnung von $\boldsymbol{R}$ und $\boldsymbol{c}$ wird ein rekursives Verfahren verwendet. Als Startwerte werden für $\boldsymbol{R}$ die Einheitsmatrix und für $\boldsymbol{c}$ geeignete initiale Netzparameter $\hat{\theta}_i(0)$ gewählt. Bei beispielhaft vier zu schätzenden Netzparameterwerten ergibt sich daraus folgende Matrix als Startmatrix:

$$Q^T(\Psi \quad y) = (R \quad c) = \begin{pmatrix} 1 & 0 & 0 & 0 & \hat{\theta}_1(0) \\ 0 & 1 & 0 & 0 & \hat{\theta}_2(0) \\ 0 & 0 & 1 & 0 & \hat{\theta}_3(0) \\ 0 & 0 & 0 & 1 & \hat{\theta}_4(0) \end{pmatrix}$$

$$(\text{Gl. } 14)$$

Diese Startmatrix wird nun um einen ersten Messwertsatz ($\psi^T y'$) erweitert und führt auf die Rekursionsmatrix

$$\begin{pmatrix} R & c \\ \psi^T & y' \end{pmatrix} = \begin{pmatrix} 1 & 0 & 0 & 0 & \hat{\theta}_1(0) \\ 0 & 1 & 0 & 0 & \hat{\theta}_2(0) \\ 0 & 0 & 1 & 0 & \hat{\theta}_3(0) \\ 0 & 0 & 0 & 1 & \hat{\theta}_4(0) \\ \psi_1 & \psi_2 & \psi_3 & \psi_4 & y' \end{pmatrix}$$

$$(\text{Gl. } 15)$$

Mit Hilfe der Givens-Rotation können durch wiederholte linksseitige Multiplikation mit Rotationsmatrizen $G_{i,j}$ gezielt Nulleinträge erzeugt werden. Wenn das Element (*i,j*) genullt werden soll, dann hat die Rotation nur auf die Zeilen *i* und *j* Einfluss. Damit kann die Rekursionsmatrix aus Gleichung (15) in die Form

$$\begin{pmatrix} R & c \\ \psi^T & y' \end{pmatrix} \rightarrow \begin{pmatrix} R' & c' \\ 0^T & \tilde{c} \end{pmatrix}$$

$$(\text{Gl. } 16)$$

transformiert werden:

$$\boldsymbol{G}_{5,1}\begin{pmatrix} 1 & 0 & 0 & 0 & \hat{\theta}_1(0) \\ 0 & 1 & 0 & 0 & \hat{\theta}_2(0) \\ 0 & 0 & 1 & 0 & \hat{\theta}_3(0) \\ 0 & 0 & 0 & 1 & \hat{\theta}_4(0) \\ \psi_1 & \psi_2 & \psi_3 & \psi_4 & y' \end{pmatrix} \rightarrow \boldsymbol{G}_{5,2}\begin{pmatrix} * & * & * & * & * \\ 0 & 1 & 0 & 0 & \hat{\theta}_2(0) \\ 0 & 0 & 1 & 0 & \hat{\theta}_3(0) \\ 0 & 0 & 0 & 1 & \hat{\theta}_4(0) \\ 0 & * & * & * & * \end{pmatrix}$$

$$\rightarrow \boldsymbol{G}_{5,3}\begin{pmatrix} * & * & * & * & * \\ 0 & * & * & * & * \\ 0 & 0 & 1 & 0 & \hat{\theta}_3(0) \\ 0 & 0 & 0 & 1 & \hat{\theta}_4(0) \\ 0 & 0 & * & * & * \end{pmatrix} \rightarrow \boldsymbol{G}_{5,4}\begin{pmatrix} * & * & * & * & * \\ 0 & * & * & * & * \\ 0 & 0 & * & * & * \\ 0 & 0 & 0 & 1 & \hat{\theta}_4(0) \\ 0 & 0 & 0 & * & * \end{pmatrix}$$

$$\rightarrow \begin{pmatrix} * & * & * & * & * \\ 0 & * & * & * & * \\ 0 & 0 & * & * & * \\ 0 & 0 & 0 & * & * \\ 0 & 0 & 0 & 0 & \tilde{c} \end{pmatrix}$$

(Gl. 17)

Die initialen Startwerte werden iterativ durch eine neuberechnete obere Dreiecksmatrix $\boldsymbol{R'}$ und einen neuberechneten Ergebnisvektor $\boldsymbol{c'}$ ersetzt. Mit der neuberechneten oberen Dreiecksmatrix $\boldsymbol{R'}$ und dem neuberechneten Ergebnisvektor $\boldsymbol{c'}$ kann der geschätzte Netzparametervektor $\hat{\theta}$ gemäß der QR-Matrixgleichung (13) durch Rückwärtseinsetzen ermittelt werden.

Am Ende eines jeden Verfahrensdurchlaufs erfolgt in Schritt S8 eine Berechnung des jeweiligen Isolationswiderstands $R_1$, $R_2$ und der jeweiligen Ableitkapazität $C_1$, $C_2$ aus den geschätzten Netzparametern $\hat{\theta}_i$.

Die Einbeziehung der Netzspannung in die Beschreibung der (aus dem Ersatzschaltbild gewonnenen) Strom-Spannungs-Beziehungen ermöglicht somit, den Isolationswiderstand und die Ableitkapazität leiterselektiv, also für jeden aktiven Leiter separat, zu bestimmen. Die Aufteilung auf die einzelnen aktiven Leiter vereinfacht eine Fehlersuche in dem ungeerdeten DC-Stromversorgungssystem.

Auf Basis der in den Gleichungen (15) und (16) dargestellten Rekursionsmatrix wird der Verfahrensablauf mit dem nächsten, zu dem aktuellen Messzeitpunkt vorliegenden Messwertsatz ($\psi^T$ $y'$), mit der neuberechneten oberen Dreiecksmatrix $\boldsymbol{R'}$ und mit dem neuberechneten Ergebnisvektor $\boldsymbol{c'}$ kontinuierlich wiederholt.

Dabei können vor dem nächsten Verfahrensdurchlauf die neuberechnete obere Dreiecksmatrix $\boldsymbol{R'}$ und der neuberechnete Ergebnisvektor $\boldsymbol{c'}$ mit einem Forgetting Faktor $\sqrt{\lambda}$ multipliziert werden, um eine zeitliche Gewichtung der Messwerte zu erreichen.

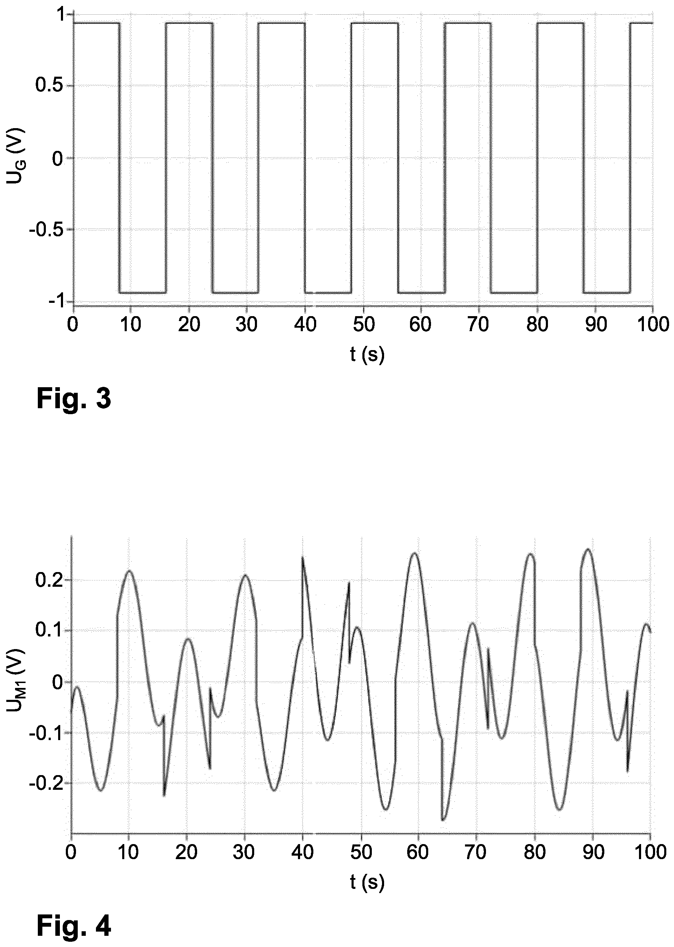

**Fig. 3** zeigt eine Rechteckimpuls-förmige, von dem Messspannungsgenerator erzeugte Messspannung $U_G$, die dem ungeerdeten DC-Stromversorgungssystem 2 überlagert wird. Da der maximale Aussteuerbereich 1.2V beträgt, weist die Messspannung $U_G$ eine Amplitude von annähernd 1V auf. Die Pulsbreite beträgt 8s.

In **Fig. 4** ist ein über einem Messwiderstand $R_M$ gemessener Spannungsabfall $U_{M1}$ dargestellt, wenn die Netzspannung $U_N$ eine niederfrequente Netzspannungsänderung von 0.1Hz aufweist.

Der Spannungsabfall $U_{M1}$ setzt sich aus der Überlagerung der sich ändernden Netzspannung $U_N$ und der Rechteckimpuls-förmigen Messspannnung $U_G$ zusammen. Deutlich zu erkennen ist, dass die niederfrequente Netzspannungsänderung dominiert und damit auf die Messung einen störenden Einfluss ausübt. Gemäß dem Stand der Technik ist daher eine Störunterdrückung, beispielsweise durch Filterung, erforderlich. Auf eine derartige, insbesondere bei niederfrequenten Netzspannungsänderungen schaltungstechnisch aufwendige, Maßnahme zur Unterdrückung von Störeffekten kann bei Anwendung des erfindungsgemäßen Verfahrens verzichtet werden. In vorteilhafter Weise ist es erfindungsgemäß auch unter diesen schwierigen Bedingungen, also bei verfälschten Messsignalen, noch möglich, verwertbare Messwerte zu ermitteln.

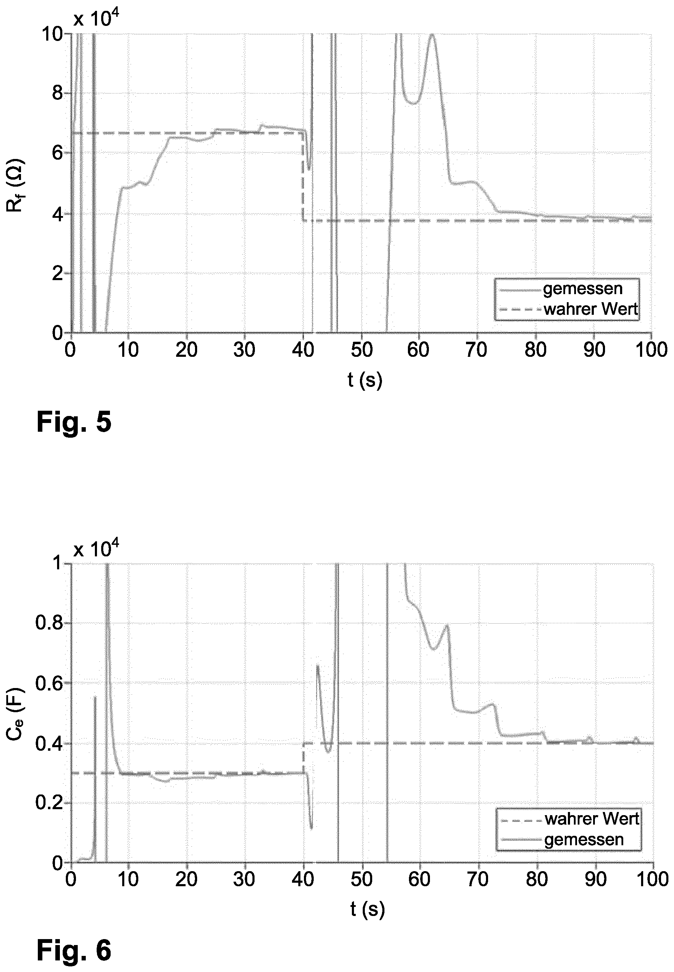

**Fig. 5** zeigt einen Zeitverlauf eines berechneten Isolationswiderstands $R_f$ (hier als Gesamtwiderstand der Parallelschaltung der Isolationswiderstände $R_1$ und $R_2$) bei einer sprunghaften (testweisen) Änderung des wahren Isolationswiderstands nach 40s unter den Bedingungen der durch die Netzspannungsänderung gekennzeichneten Netzspannung $U_N$ aus Fig. 4.

Es dauert zunächst etwa 20s, bis der berechnete Isolationswiderstand Rf in etwa dem wahren Wert entspricht. Nach der sprunghaften Änderung des wahren Isolationswiderstands zum Zeitpunkt 40s dauert es etwa 30s bis das Messverfahren wieder den wahren Wert des Isolationswiderstands liefert.

**Fig. 6** zeigt in analoger Weise zu Fig. 5 einen Zeitverlauf einer berechneten Ableitkapazität $C_e$ (hier als Summe der Ableitkapazitäten $C_1$ und $C_2$) bei einer sprunghaften Änderung der wahren Ableitkapazität nach 40s.

**Patentansprüche**

1. Verfahren zur Bestimmung eines Isolationswiderstands ($R_1$, $R_2$) und einer Ableitkapazität ($C_1$, $C_2$) gegen Erde (PE) eines ungeerdeten DC-Stromversorgungssystems, welches eine Netzspannung ($U_N$) und aktive Leiter ($L_1$, $L_2$) aufweist, umfassend die Verfahrensschritte:

   Ankoppeln (S1) einer Messspannung ($U_G$) in Reihenschaltung mit einem Messwiderstand ($R_M$) einpolig oder zweipolig zwischen jeweils einen der aktiven Leiter ($L_1$, $L_2$) und Erde (PE),
   Messen (S2) eines Spannungsabfalls ($U_{M1}$, $U_{M2}$) über dem jeweiligen Messwiderstand ($R_M$),
   Erzeugen (S3) zeit- und wertdiskreter Abtastwertfolgen ($U_G(k)$, $U_N(k)$, $U_M(k)$) der Messspannung ($U_G$), der Netzspannung ($U_N$) und des jeweiligen Spannungsabfalls ($U_{M1}$, $U_{M2}$),
   Implementieren (S4) einer linearen Differenzengleichung mit einer gemessenen Spannung ($U_M(k)$) als Funktion der Messspannung ($U_G(k)$) und der Netzspannung ($U_N(k)$) und mit Netzparametern ($\theta_i$), die aus den Messwiderständen ($R_M$), aus den zu bestimmenden Isolationswiderständen ($R_1$, $R_2$) und aus den zu bestimmenden Ableitkapazitäten ($C_1$, $C_2$) gebildet werden,
   Implementieren (S5) eines Messwert-Gleichungssystems aus N linearen Differenzengleichungen mit den Abtastwertfolgen ($U_G(k)$, $U_N(k)$, $U_M(k)$) und den Netzparametern ($\theta_i$) für k=1, 2 bis N Messzeitpunkte mit der Abtastperiode T,
   Berechnen (S6) von geschätzten Netzparametern ($\hat{\theta}_i$) als Näherungslösung des Messwert-Gleichungssystems, wobei eine Summe der Fehlerquadrate zwischen den Netzparametern ($\theta_i$) und den geschätzten Netzparametern ($\hat{\theta}_i$) minimiert wird,
   Minimieren (S7) der Summe der Fehlerquadrate durch QR-Zerlegung einer Messwertmatrix ($\Psi$), wobei das Berechnen der QR-Zerlegung rekursiv erfolgt,
   Berechnen (S8) des jeweiligen Isolationswiderstands ($R_1$, $R_2$) und der jeweiligen Ableitkapazität ($C_1$, $C_2$) aus den geschätzten Netzparametern ($\hat{\theta}_i$),
   kontinuierliches Wiederholen der Verfahrensschritte mit den jeweils berechneten, geschätzten Netzparametern ($\hat{\theta}_i$) unter Einbeziehen der für den aktuellen Messzeitpunkt vorliegenden Abtastwerte.

2. Verfahren nach Anspruch 1,
   **dadurch gekennzeichnet,**
   **dass** die lineare Differenzengleichung durch Transformieren einer die Strom-Spannungs-Beziehungen beschreibenden linearen algebraischen Gleichung im Frequenzbereich in eine zeitkontinuierliche Differentialgleichung und deren zeitdiskrete Implementierung abgeleitet wird.

3. Verfahren nach Anspruch 1 oder 2,
   **dadurch gekennzeichnet,**
   **dass** die rekursive QR-Zerlegung auf Basis einer Rekursionsmatrix erfolgt.

4. Verfahren nach einem der Ansprüche 1 bis 3,
   **dadurch gekennzeichnet,**
   **dass** die QR-Zerlegung mittels Givens-Rotation erfolgt.

5. Verfahren nach einem der Ansprüche 1 bis 4,
   **dadurch gekennzeichnet,**
   **dass** bei der rekursiven QR-Zerlegung eine obere Dreiecksmatrix (R) und ein Ergebnisvektor (c) mit einem Forgetting Factor ($\sqrt{\lambda}$) gewichtet werden.

**Claims**

1.  A method for determining an insulation resistance ($R_1$, $R_2$) and a leakage capacitance ($C_1$, $C_2$) against ground (PE) of an ungrounded DC power supply system, which has a line voltage ($U_N$) and active conductors ($L_1$, $L_2$), the method comprising the following method steps:

    coupling (S1) a measuring voltage ($U_G$) in series to a measured resistance ($R_M$) in a unipolar or bipolar manner between one of the active conductors ($L_1$, $L_2$) and ground (PE) in each instance,

    measuring (S2) a voltage drop ($U_{M1}$, $U_{M2}$) via the corresponding measured resistance ($R_M$),

    generating (S3) time and value-discrete sample sequences ($U_G(k)$, $U_N(k)$, $U_M(k)$) of the measuring voltage ($U_G$), the line voltage ($U_N$) and the corresponding voltage drop ($U_{M1}$, $U_{M2}$),

    implementing (S4) a linear difference equation having a measuring voltage ($U_M(k)$) as a function of the measuring voltage ($U_G(k)$) and the line voltage ($U_N(k)$) and having network parameters ($\theta_i$), which are formed from the measured resistances ($R_M$), from the insulation resistances to be determined ($R_1$, $R_2$) and from the leakage capacitances to be determined ($C_1$, $C_2$),

    implementing (S5) a measured-value equation system from N linear difference equations using the sample sequences ($U_G(k)$, $U_N(k)$, $U_M(k)$) and the network parameters ($\theta_i$) for k = 1, 2 to N measuring points in time having the sampling period T,

    computing (S6) estimated network parameters ($\theta_i$) as an approximate solution of the measured-value equation system, a sum of squared residuals between the network parameters ($\theta_i$) and the estimated network parameters ($\theta_i$) being minimized,

    minimizing (S7) the sum of squared residuals via QR decomposition of a measured-value matrix ($\Psi$), the QR decomposition being computed recursively,

    computing (S8) the corresponding insulation resistance ($R_1$, $R_2$) and the corresponding leakage capacitance ($C_1$, $C_2$) from the estimated network parameters ($\hat{\theta}_i$),

    continuously repeating the method steps having the correspondingly computed, estimated network parameters ($\hat{\theta}_i$) while taking into consideration the samples available for the current measuring point in time.

2.  The method according to claim 1,
    **characterized in that**
    the linear difference equation is derived by transforming a linear algebraic equation in the frequency domain in a temporally continuous difference equation and its time-discrete implementation, the linear algebraic equation describing the current-voltage relationship.

3.  The method according to claim 1 or 2,
    **characterized in that**
    the recursive QR decomposition is carried out based on a recursion matrix.

4.  The method according to any one of the claims 1 to 3,
    **characterized in that**
    the QR decomposition is carried out by means of Givens rotation.

5.  The method according to any one of the claims 1 to 4,
    **characterized in that**
    an upper triangular matrix (R) and a result vector (c) are weighted using a Forgetting Factor ( $\sqrt{\lambda}$ ) in the recursive QR decomposition.

**Revendications**

1.  Procédé de détermination d'une résistance d'isolement ($R_1$, $R_2$) et d'une capacité de fuite ($C_1$, $C_2$) par rapport à la terre (PE) d'un système d'alimentation en courant continu non mis à la terre, qui comprend une tension de réseau ($U_N$) et des conducteurs actifs ($L_1$, $L_2$), le procédé comprenant les étapes suivantes :

    coupler (S1) une tension de mesure ($U_G$) en série à une résistance mesurée ($R_M$) de manière unipolaire ou bipolaire entre l'un des conducteurs actifs ($L_1$, $L_2$) et la terre (PE) dans chaque cas,

    mesurer (S2) une chute de tension ($U_{M1}$, $U_{M2}$) par l'intermédiaire de la résistance mesurée ($R_M$) correspondante,

générer (S3) des séquences d'échantillons ($U_G(k)$, $U_N(k)$, $U_M(k)$) discrètes en temps et en valeur de la tension de mesure ($U_G$), de la tension de réseau ($U_N$) et de la chute de tension ($U_{M1}$, $U_{M2}$) correspondante,

mettre en œuvre (S4) une équation différentielle linéaire ayant pour variable la tension de mesure ($U_M(k)$) en fonction de la tension de mesure ($U_G(k)$) et de la tension de réseau ($U_N(k)$) et ayant des paramètres de réseau ($\theta_i$), qui sont formés à partir des résistances mesurées ($R_M$), des résistances d'isolement ($R_1$, $R_2$) à déterminer et des capacités de fuite ($C_1$, $C_2$) à déterminer,

mettre en œuvre (S5) un système d'équations de valeurs mesurées à partir de N équations différentielles linéaires en utilisant les séquences d'échantillons ($U_G(k)$, $U_N(k)$, $U_M(k)$) et les paramètres de réseau ($\theta_i$) pour k = 1, 2 à N instants de mesure ayant la période d'échantillonnage T,

calculer (S6) des paramètres de réseau ($\theta_i$) estimés comme solution approximative du système d'équations de valeurs mesurées, la somme des résiduels des carrés entre les paramètres de réseau ($\theta_i$) et les paramètres de réseau ($\theta_i$) estimés étant minimisée,

minimiser (S7) la somme des résiduels des carrés par l'intermédiaire de la décomposition QR d'une matrice de valeurs mesurées ($\Psi$), la décomposition QR étant calculée de manière récursive,

calculer (S8) la résistance d'isolement ($R_1$, $R_2$) correspondante et la capacité de fuite ($C_1$, $C_2$) correspondante à partir des paramètres de réseau ($\hat{\theta}_i$) estimés,

répéter en continu les étapes de procédé avec les paramètres de réseau ($\theta_i$) estimés calculés de manière correspondante, tout en prenant en considération les échantillons disponibles pour l'instant de mesure courant.

**2.** Procédé selon la revendication 1,
**caractérisé en ce que**
l'équation différentielle linéaire est dérivée en transformant une équation algébrique linéaire dans le domaine fréquentiel en une équation différentielle temporellement continue et sa mise en œuvre discrète en le temps, l'équation algébrique linéaire décrivant la relation entre le courant et la tension.

**3.** Procédé selon la revendication 1 ou la revendication 2,
**caractérisé en ce que**
la décomposition QR récursive est effectuée sur la base d'une matrice de récursion.

**4.** Procédé selon l'une quelconque des revendications 1 à 3,
**caractérisé en ce que**
la décomposition QR est effectuée au moyen d'une rotation de Givens.

**5.** Procédé selon l'une quelconque des revendications 1 à 4,
**caractérisé en ce**
**qu'**une matrice triangulaire supérieure (R) et un vecteur de résultat (c) sont pondérés à l'aide d'un facteur d'oubli ($\sqrt{\lambda}$) dans la décomposition récursive QR.

**Fig. 1**

EP 4 673 755 B1

**Fig. 2**

**Fig. 3**

**Fig. 4**

**Fig. 5**

**Fig. 6**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2433147 B1